# EUROPEAN PATENT SPECIFICATION

(11) **EP 2 282 331 B1**
(45) Date of publication and mention of the grant of the patent: **13.03.2013**
(21) Application number: 10171218.0
(22) Date of filing: 29.07.2010
(51) Int. Cl.: H01L 21/687

(54) **Substrate position alignment mechanism**
Substratpositionsausrichtungsmechanismus
Mécanisme d'alignement de la position de substrats,

(30) Priority: 30.07.2009 JP 2009177340
(43) Date of publication of application: 09.02.2011
(73) Proprietor: TOKYO ELECTRON LIMITED, Minato-ku Tokyo 107-6325 (JP)
(72) Inventor: Ozawa, Jun, Yamanashi 407-8511 (JP); Kumasaka, Hajime, Yamanashi 407-8511 (JP)
(74) Representative: HOFFMANN EITLE

(56) References cited:
- WO-A1-97/19868
- KR-A- 20070 059 691
- US-A1- 2003 161 706

## Description

### Field of the Invention

The present invention relates to a position alignment mechanism for performing position alignment of a substrate accommodated in a vessel, a vacuum prechamber using the position alignment mechanism and a substrate processing system having the vacuum prechamber, wherein the position alignment is carried out in the course of performing vacuum processing on the substrate such as an FPD (Flat Panel Display), a solar cell or the like.

### Background of the Invention

Japanese Patent Application Publication No. H10-98085 describes, e.g., a multi chamber type substrate processing system for the manufacture of a rectangular substrate such as an FPD, a solar cell or the like. The processing system includes a processing chamber for performing a predetermined vacuum processing such as etching, film formation or the like; a common vacuum transfer chamber to which the processing chamber and a preheating chamber for pre-heating the substrate to a processing temperature are connected, the transfer chamber having a transfer mechanism for transferring the substrate to the processing chamber and the preheating chamber; and a load-lock chamber serving as a vacuum prechamber through which the substrate is transferred between the transfer chamber and the atmosphere.

In the above-described substrate processing system the substrate is transferred to the processing chamber or the like by the transfer mechanism of the transfer chamber after the substrate is position-aligned in the lead-lock chamber. Accordingly, the substrate is transferred to a precise position in the processing chamber or the like. As for a technique for performing such position alignement, there are used positioners for linearly moving forward and backward along a diagonal direction to press diagonally opposite corners of the rectangular substrate (see. e.g., Japanese Patent Application Publication No. 2000-306580).

Decently, while a rectangular substrate tends to become increased in size, there is a demand to scale down a load-lock chamber serving as a vacuum prechamber repeatedly switched between the atmospheric atmosphere (about 1 atm) and a depressurized atmosphere. However, the positioners disclosed in Japanese Patent Application Publication No. 2000-306980 linearly move forward and backward along the diagonal direction to press diagonally opposite corners of the rectangular substrate so that a large space is required to perform such technique, and thus, the load-lock chamber cannot be sufficiently scaled down.

KR 20070059691 A discloses an arrangement having elements equivalent to those recited in the preamble to Claim 1 below; WO 97/19868 A1 EP 0 777 264 A1 and US 2003/161706 A1 each form part of the prior art with respect to the present invention.

### Summary of the Invention

In view of the above, embodiments of the present invention can provide a substrate position alignment mechanism capable of minimizing a space required for position alignment of a substrate in a chamber, a vacuum prechamber using the substrate position alignment mechanism, and a substrate processing system having such vacuum prechamber.

In accordance with a first aspect of the present invention, there is provided a substrate position alignment mechanism as recited in Claim 1 below.

In accordance with a second aspect of the present invention, there is provided a vacuum prechamber as recited in Claim 11 below.

In accordance with a third aspect of the present invention, there is provided a substrate processing system as recited in Claim 12 below.

Dependent claims are directed to particular embodiments of the present invention.

### Brief Description of the Drawings

For a better understanding of the present invention and to show how the same may be carried into effect, reference will be made, by way of example only, to the accompanying drawings, in which:
Fig. 1 is a plane view schematically showing a substrate processing system having a load-lock chamber serving as a vacuum prechamber in accordance with an embodiment of the present invention;
Fig. 2 schematically illustrates a substrate transfer device of the substrate processing system shown in Fig. 1;
Fig. 3 provides a vertical cross sectional view of the load-lock chamber of the substrate processing system shown in Fig. 1;
Fig. 4 depicts a horizontal cross sectional view of the load-lock chamber of the substrate processing system shown in Fig. 1,
Figs. 5A and 5B describe schematic views for explaining structures of a supporting pin 103 and a movable support 104 used for a position alignment support unit of the load-lock chamber shown in Fig. 4 ;
Fig. 6 presents a side view showing configurations of a loading rack 85 and en unloading rack 120 of the load-lock chamber shown in Fig. 4 and an arrangement relationship thereof;
Fig. 7 shows a schematic view of pressing units 90 and 91 of a position alignment mechanism 86 in the load-lock chamber shown in Fig. 4;
Figs. 8A and 8B provide a side view and a top view of a pressing unit 92 of the position alignment mechanism 86 in the load-lock chamber shown in Fig. 4 ;
Figs. 9A to 9D explain a position alignment sequence of the position alignment mechanism 86 in the load-lock chamber shown in Fig. 4; and
Fig. 10 is a schematic view for explaining another example of the position alignement support unit in the load-lock chamber shown in Fig. 4.

### Detailed Description

Embodiments of the present invention will be described with reference to the accompanying drawings which form a part hereof. Throughout the drawings, like reference numerals will be given to like parts.

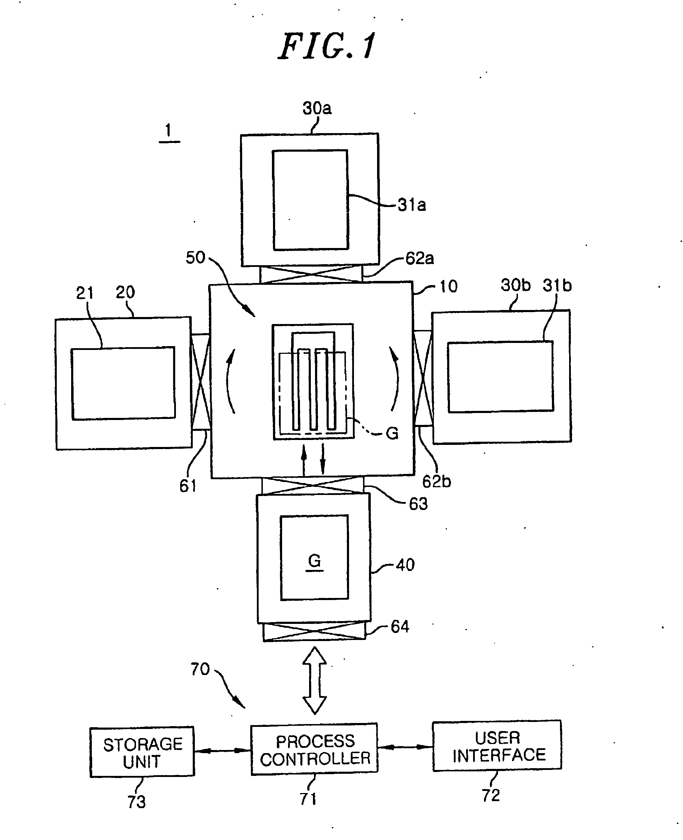

Fig. 1 is a top view schematically showing a substrate processing system having a load-lock chamber serving as a vacuum prechamber in accordance with an embodiment of the present invention. A substrate processing system 1 is configured as an apparatus for performing, e.g., etching or film formation, on a rectangular substrate, e.g., a glass substrate for use in an FPD such as a liquid crystal display (LCD) or a glass substrate for use in a solar cell.

As shown in Fig. 1, the substrate processing system 1 includes: a common transfer chamber 10; a preheating chamber 20, connected to the common transfer chamber 10, for pre-heating a substrate G; two processing chambers 30a and 30b for performing processing such as etching, film formation or the like on the substrate G; a load-lock chamber 40 for transferring the substrate G between a substrate accommodating carrier (not shown) disposed in the atmosphere and the common transfer chamber 10 maintained in a vacuum state; and a substrate transfer device 50, provided in the common transfer chamber 10, for transferring the substrate G.

The common transfer chamber 10 is formed in a rectangular shape when seen from the top, and the preheating chamber 20, the processing chambers 30a and 30b and the load-lock chamber 40 are connected to side surfaces of the common transfer chamber 10 via gate valves 61, 62a, 62b and 63, respectively. Further, a gate valve 64 is provided at the side of the load-lock chamber 40 that faces the atmosphere. Although the common transfer chamber 10 of the present embodiment has the rectangular shape when seen from the top, the common transfer chamber 10 may have a polygonal (e.g., hexagonal or octagonal) shape when seen from the top, to which a preheating chamber, a processing chamber or a load-lock chamber can be additionally connected.

In the present embodiment, the common transfer chamber 10, the preheating chamber 20 and the processing chambers 30a and 30b are configured as vacuum chambers respectively having therein mounting tables 21, 31a and 31b, each for mounting thereon the substrate G and maintained in a predetermined depressurized state. Furthermore, the load-lock chamber 40 is provided to transfer the substrate G between a substrate accommodating carrier disposed in the atmosphere (not shown) and the common transfer chamber 10 maintained in a vacuum state, and serves as a vacuum prechamber that can be switched between the atmospheric atmosphere and the depressurized atmosphere.

The substrate processing system 1 is configured to simultaneously process a plurality of, e.g., three, substrates G horizontally mounted at different heights. The substrates G are loaded together from the external substrate accommodating carrier into the load-lock chamber 40 via the gate valve 64 by a transfer unit (not shown) disposed in the atmosphere. The loaded substrates G are transferred from the load-lock chamber 40 to the common transfer chamber 10 via the gate valve 63, from the common transfer chamber 10 to the preheating chamber 20 via the gate valve 61, and from the preheating chamber 20 to the processing chambers 30a or 30b via the gate valve 62a or 62b. The substrates G processed in the processing chamber 30a or 30b are transferred from the processing chamber 30a or 30b to the common transfer chamber 10 via the corresponding gate valve 62a or 62b, and from the common transfer chamber 10 to the load-lock chamber 40 via the gate valve 63. Then, the processed substrates G are unloaded from the load-lock chamber 40. Although the processing chambers 30a and 30b perform the same process in the present embodiment, different processes may be carried out in the processing chambers 30a and 30b. In other words, a first process may be carried out in the processing chamber 30a and a following second process may be performed successively in the processing chamber 30b.

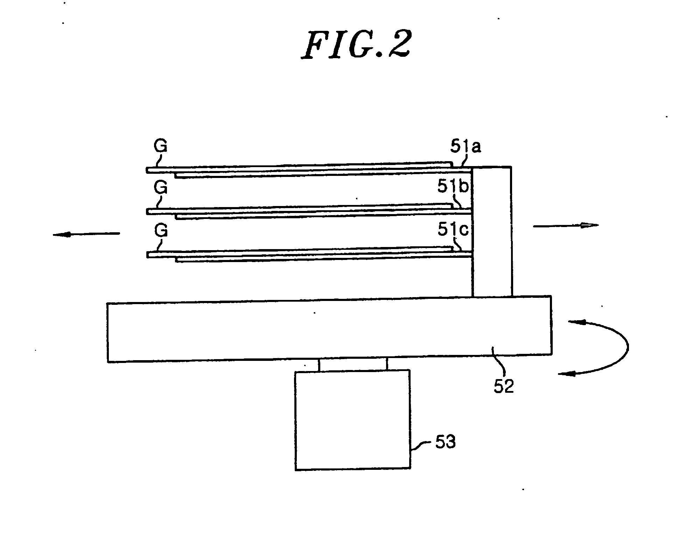

The substrate transfer device 50 transfers a plurality of, e.g., three, substrates G at a time between the common transfer chamber 10, the preheating chamber 20, the processing chambers 30a and 30b and the load-lock chamber 40. As illustrated in Fig. 2, three substrate support arms 51a, 51b and 51c arranged above one another at different heights are configured to linearly move on a rotatable base member 52. By moving the substrate support arms 51a to 51c back and forth and rotating the base member 52, the substrate support arms 51a to 51c can access the preheating chamber 20, the processing chambers 30a and 30b and the load-lock chamber 40. The reference numeral 53 indicates a driving unit for rotating the base member 52.

The respective components of the substrate processing system 1 are controlled by a control unit (computer) 70. The control unit 70 includes a process controller 71 having a micro processor. The process controller 71 is connected to a user interface 72 including a keyboard through which an operator inputs a command or the like to manage the substrate processing system 1, a display for visually displaying an operation status of the substrate processing system 1, and the like. Further, the process controller 71 is connected to a storage unit 73 which stores therein control programs to be used in realizing various processes performed in the substrate processing system 1 under the control of the process controller 71, and control programs or recipes to be used in performing predetermined processing in the substrate processing system 1 under processing conditions. The storage unit 73 has a storage medium which stores therein the recipes or the like.

The storage medium may be a hard disk, a semiconductor memory or a portable storage medium such as a CD-ROM, a DVD, a flash memory or the like. If necessary, a certain recipe is retrieved from the storage unit 73 in response to an instruction from the user interface 72 or the like and is executed by the process controller 71, thereby performing a desired process in the substrate processing system 1 under control of the process controller 71.

In the substrate processing system 1 configured as described above, first of all, the gate valve 64 is opened and a plurality of, e.g., three, unprocessed substrates G is loaded into the load-lock chamber 40 in the atmospheric atmosphere by a substrate transfer device (not shown) disposed in the atmosphere.

Next, the gate valve 64 is closed, and the inside of the load-lock chamber 40 is set to be changed to a depressurized atmosphere. Then, the gate valve 63 is opened, and the substrate support arms 51a to 51c of the substrate transfer device 50 simultaneously enter the load-lock chamber 40 and receive unprocessed substrates G loaded into the load-lock chamber 40. Thereafter, the substrate support arms 51a to 51c of the substrate transfer device 50 return to the common transfer chamber 10, and the gate valve 63 is closed.

Next, the base member 52 of the substrate transfer device 50 is rotated so that the substrate support arms 51a to 51c are positioned to face the preheating chamber 20. Then, the gate valve 61 is opened, and the substrate support arms 51a to 51c enter the preheating chamber 20 to transfer unprocessed substrates G to the preheating chamber 20. Thereafter, the substrate support arms 51a to 51c return to the common transfer chamber 10, and the gate valve 61 is closed so that pre-heating of the substrates G can be started in the preheating chamber 20.

Upon completion of the pre-heating, the gate valve 61 is opened, and the substrate support arms 51a to 51c enter the preheating chamber 20 to thereby receive the pre-heated substrates G. Next, the substrate support arms 51a to 51c return to the common transfer chamber 10, and the gate valve 61 is closed. Then, the base member 52 is rotated so that the substrate support arms 51a to 51c are positioned to face the processing chamber 30a (or 30b). Thereafter, the gate valve 62a (or 62b) is opened, and the substrate support arms 51a to 51c enter the processing chamber 30a (or 30b) to transfer the pre-heated substrates G to the processing chamber 30a (or 30b). Next, the substrate support arms 51a to 51c return to the common transfer chamber 10, and the gate valve 62a (or 62b) is closed so that processing in the processing chamber 30a (or 30b) is started.

Upon completion of the processing, the gate valve 62a (or 62b) is opened, and the substrate support arms 51a to 51c enter the processing chamber 30a (or 30b) to receive the processed substrates G. Then, the substrate support arms 51a to 51c return to the common transfer chamber 10, and the gate valve 62a (or 62b) is closed. Thereafter, the base member 52 is rotated so that the substrate support arms 51a to 51c are positioned to face the load-lock chamber 40. Next, the gate valve 63 is opened, and the substrate support arms 51a to 51c enter the load-lock chamber 40 to transfer the processed substrates G to the load-lock chamber 40. Thereafter, the substrate support arms 51a to 51c return to the common transfer chamber 10, and the gate valve 63 is closed, and the inside of the load-lock chamber 40 is set to be changed to the atmospheric atmosphere. Then, the gate valve 64 is opened, and the processed substrates G are unloaded from the load-lock chamber 40 by a transfer unit (not shown) disposed in the atmosphere.

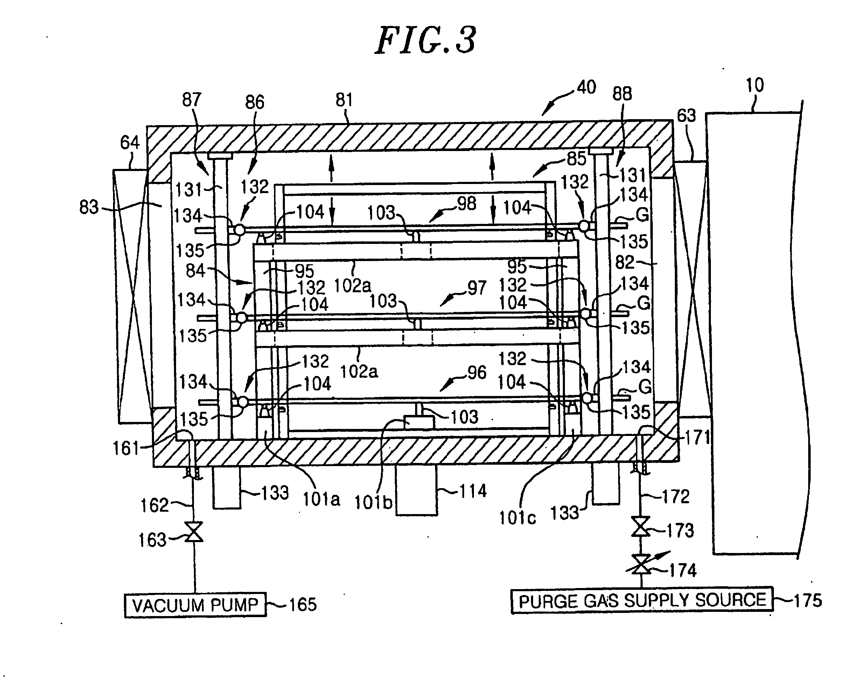

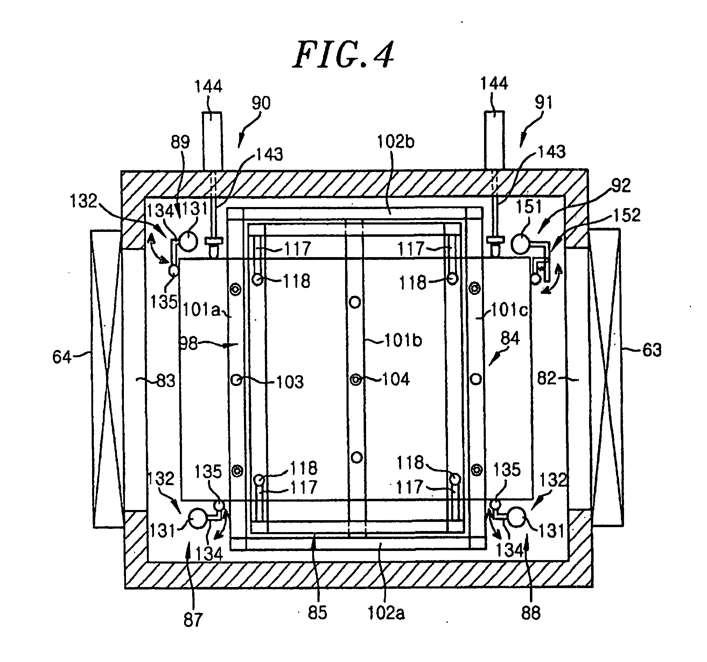

Hereinafter, the load-lock chamber 40 will be described in detail. Figs. 3 and 4 respectively provide a vertical cross sectional view and a horizontal cross sectional view of the load-lock chamber 40.

The load-lock chamber 40 has a vessel 81. An opening 82 that makes the vessel 81 capable of communicating with the common transfer chamber 10 maintained in a vacuum state is formed on one sidewall of the vessel 81, and an opening 83 that makes the vessel 81 capable of communicating with the atmosphere is formed on the opposite sidewall. Further, the opening 82 can be opened and closed by the gate valve 63, and the opening 83 can be opened and closed by the gate valve 64.

A position alignment rack 84 for performing position alignment of three substrates G is fixed to a bottom portion of the vessel 81, and a loading rack 85 for holding the substrates G to be loaded into the common transfer chamber 10 is provided inside the position alignment rack 84 so as to be movable vertically. Moreover, an unloading rack for holding the substrates to be unloaded from the common transfer chamber 10 is disposed inside the loading rack 85. Since, however, its configuration is substantially the same as that of the loading rack 85, the illustration thereof is omitted in Figs. 3 and 4. Each of the position alignment rack 84, the loading rack 85 and the unloading rack is configured to horizontally mount the three rectangular substrates G above one another at three different heights with shorter sides thereof being in parallel with the openings 82 and 83.

Further, the vessel 81 has therein a position alignment mechanism 86 for performing position alignment of the substrates G mounted on the position alignment rack 84. The position alignment mechanism 86 includes two position alignment units 87 and 88 to be in contact with one longer side of each substrate G; a position alignment unit 89 to be in contact with one shorter side of each substrate G; two pressing units 90 and 91 oppositely arranged to the position alignment units 87 and 88 to press the other longer side of each substrate G; and a pressing unit 92 oppositely arranged to the position alignment unit 89 to press the other shorter side of each substrate G. The substrates G are position-aligned by determining positions and angles in the shorter side direction of the substrates G by the position alignment units 87 and 88 and positions in the longer side direction of the substrates G by the position alignment unit 89 and then pressing the substrates G by the pressing units 90, 91 and 92.

The position alignment rack 84 has four support columns 95 extending upward from the bottom portion of the vessel 81; a second position alignment support unit 97 formed at portions of support columns 95 corresponding to the height of the second (intermediate) substrate G; and a third position alignment support unit 98 formed at portions corresponding to the height of the third (uppermost) substrate. The second position alignment support unit 97 is provided to support the second substrate G and the third position alignment support unit 98 is provided to support the third substrate. Moreover, a first position alignment support unit 96 for supporting the first (lowermost) substrate G is formed at the bottom of the vessel 81.

Each of the second and the third position alignment support unit 97 and 98 includes three shorter side frames 101a, 101b and 101c formed along the substrate shorter sides and two longer side frames 102a and 102b formed along the substrate longer sides. The first position alignment support unit 96 includes three shorter side frames 101a, 101b and 101c formed at the bottom of the vessel 81 along the substrate shorter sides.

Each of the first to the third position alignment support unit 96 to 98 includes four support pins 103 and five movable supports 104 to support the substrate, wherein the support pins and the movable supports are arranged alternately on the shorter side frames 101a to 101c. To be specific, the second shorter side frame 101b provided at a position corresponding to the center of the substrate G has the one of movable supports 104 at its center and two of the support pins 103 at opposite sides thereof, and each of the shorter side frames 101a and 101c has one of the support pins 103 at its center and two of the movable supports 104 at opposite sides thereof.

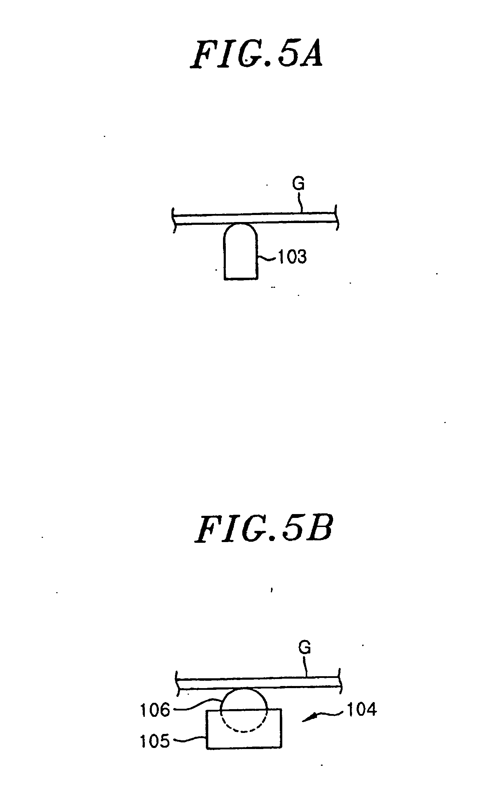

As shown in Fig. 5A, the supporting pin 103 is fixedly disposed to support the substrate G on its hemispherical leading end portion, so that a comparatively large frictional force is generated during movement of the substrate G. On the other hand, the movable support 104 has a structure in which a ball 106 is inserted into a receiving portion 105 so as to be freely rotatable and the substrate G is supported by the ball 106 as shown in Fig. 5B, so that a frictional force is hardly generated during movement of the substrate G. Therefore, by providing the supporting pins 103 and the movable supports 104 together, a proper frictional force can be exerted on the substrate G while the substrate G is supported.

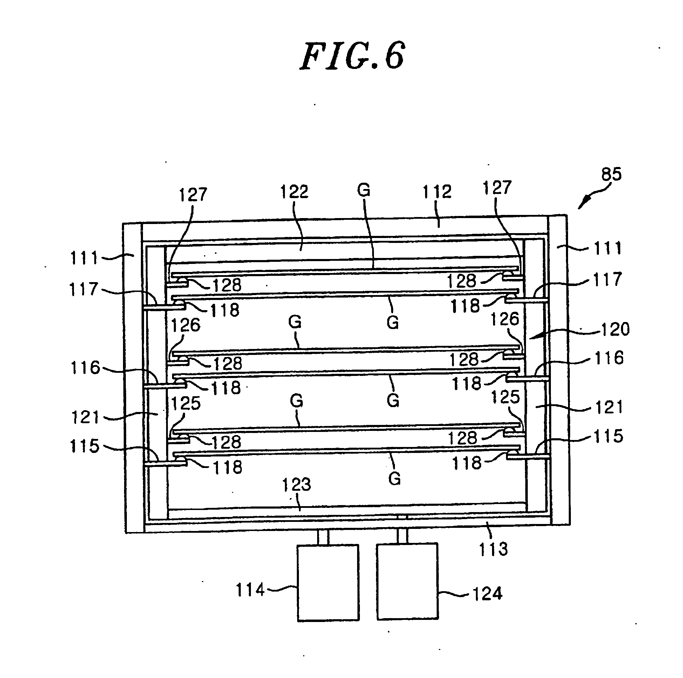

Fig. 6 is a side view of the loading rack 85 and the unloading rack 120 in the load-lock chamber 40 seen from the common transfer chamber 10. As can be seen from Fig. 6, the loading rack 85 has a frame structure having four vertical frames 111, four upper horizontal frames 112 connecting upper ends of the four vertical frames 111 and four lower horizontal frames 113 connecting lower ends of the four vertical frames 111. The loading rack 85 is formed in a rectangular cuboid shape as a whole and moves vertically by a cylinder mechanism 114 provided below the vessel 81. When the substrate support arms 51a to 51c of the substrate transfer device 50 enter the load-lock chamber 40, the loading rack 85 is raised in harmony therewith to transfer the substrates G to the substrate support arms 51a to 51c.

The loading rack 85 has a first loading support 115 for supporting the first (lowermost) substrate G, a second loading support 116 for supporting the second (intermediate) substrate G, and a third loading support 117 for supporting the third (uppermost) substrate G. Each of the first to the third loading support 115 to 117 has four support members extending horizontally from corresponding positions of the four vertical frames 111 and substrate support pins 118 formed at the support members.

As described above, the unloading rack has the similar structure as that of the loading rack 85, and its configuration and arrangement relationship with respect to the loading rack 85 are shown in Fig. 6. Specifically, the unloading rack 120 is disposed inside the loading rack 85 and has a frame structure having four vertical frames 121, four upper horizontal frames 122 connecting upper ends of the four vertical frames 121 and four lower horizontal frames 123 connecting lower ends of the four vertical frames 121. The unloading rack 120 is formed in a rectangular cuboid shape as a whole and moves vertically by a cylinder mechanism 124 provided below the vessel 81. When the substrate support arms 51a to 51c of the substrate transfer device 50 having the processed substrates G thereon enter the load-lock chamber 40, the unloading rack 120 is raised in harmony therewith to receive the substrates G from the substrate support arms 51a to 51c.

The unloading rack 120 has a first unloading support 125 for supporting the first (lowermost) substrate G, a second unloading support 126 for supporting the second (intermediate) substrate G, and a third unloading support 127 for supporting the third (uppermost) substrate G. Each of the first to the third unloading support 125 to 127 has four support members extending horizontally from corresponding positions of the four vertical frames 121 and substrate support pins 128 formed at the support members.

When exchanging the substrates G, the substrate support arms 51a to 51c of the substrate transfer device 50 transfer the processed substrates G onto the substrate support pins 128 of the first to the third unloading support 125 to 127 and then receive unprocessed substrates G supported by the substrate support pins 118 of the first to the third loading support 115 to 117.

Referring back to Figs. 3 and 4, each of the three position alignment units 87 to 89 of the position alignment mechanism 86 has a rotatable shaft 131 extending in a vertical direction; three position alignment members 132 attached to the shaft 131 for performing position alignment of the substrates G supported by the first to the third position alignment support unit 96 to 98 while being in contact with the substrates G; and a rotation driving mechanism 133 for controlling the position of the position alignment members 132 by rotating the shaft 131. Each of the position alignment members 132 has an arm 134 extending from the shaft 131 and a resin contactor 135 which contacts with a corresponding substrate G.

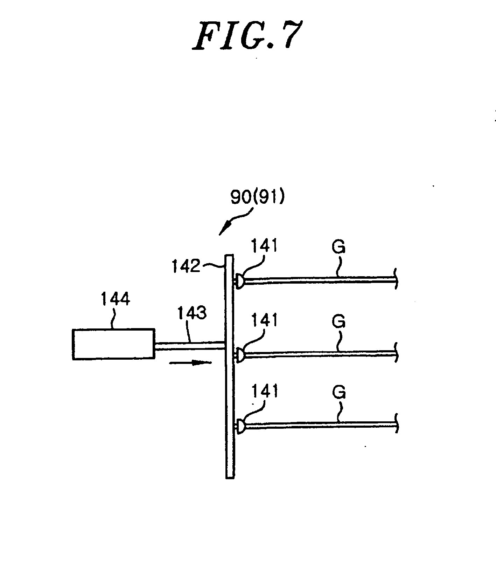

As shown in Fig. 7, each of the pressing units 90 and 91 of the position alignment mechanism 86 includes: three pressing members 141 for pressing the substrates G supported by the first to the third position alignment support unit 96 to 98; a vertically extending pressing member 142 to which the three pressing members 141 are attached; and a cylinder mechanism 144 having a piston 143 for pressing the pressing member 142.

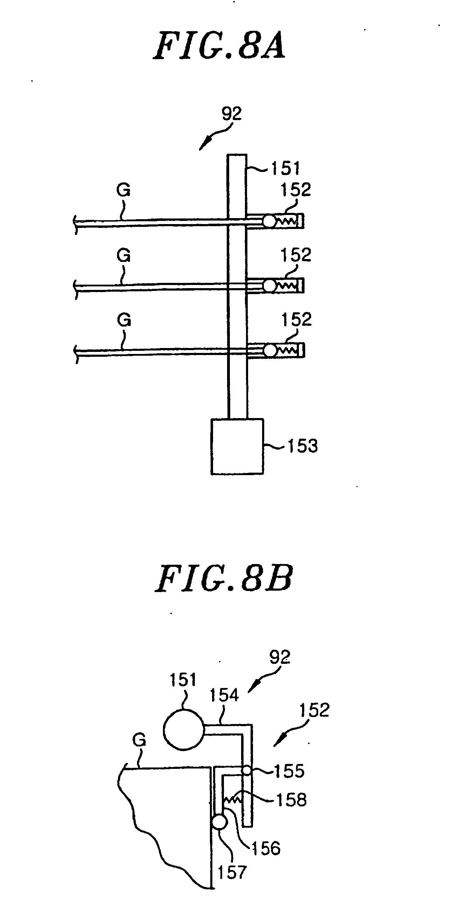

Further, as shown in Figs. 8A and 8B, the pressing unit 92 of the position alignment mechanism 86 includes: a rotatable shaft 151 extending in a vertical direction; three pressing members 152, attached to the shaft 151, for pressing the substrates G supported by the first to the third position alignment support unit 96 to 98; and a rotation driving mechanism 153 for rotating the shaft 151 to cause the pressing members 152 to press the substrates G. Each pressing member 152 has a first arm 154 extending from the shaft 151; a second arm 156 connected to the first arm 154 by a link 155; a resin pressing member 157, provided at a leading end of the second arm 156, for pressing a corresponding substrate G; and a coil spring 158 connecting between the first arm 154 and the second arm 156. Due to the presence of the coil spring 158, the substrate G is prevented from being damaged when being in contact with the position alignment unit 89.

Referring back to Fig. 3, a gas exhaust port 161 and a purge gas supply port 171 are installed at the bottom of the vessel 81. The gas exhaust port 161 is connected to a gas exhaust line 162, and an opening/closing valve 163 and a vacuum pump 165 are installed in the gas exhaust line 162. Further, the purge gas supply port 171 is connected to a purge gas supply line 172, and an opening/closing valve 173, a flow rate control valve 174 and a purge gas supply source 175 are installed in the purge gas supply line 172. In order to set the inside of the vessel 81 in a depressurized atmosphere, the opening/closing valve 173 is closed, and the opening/closing valve 163 is opened to exhaust the inside of the vessel 81 by a vacuum pump. In order to set the vessel 81 in the atmospheric atmosphere, the opening/closing valve 163 is closed, and the opening/closing valve 173 is opened to supply a purge gas such as Nitrogen gas or the like from the purge gas supply source 175 into the vessel 81 at a flow rate controlled by the flow rate control valve 174.

The following is a description of the position alignment operation in the load-lock chamber 40 serving as a vacuum prechamber configured as described above.

First, in a state where the inside of the vessel 81 is set in the atmospheric atmosphere, the gate valve 64 is opened and the substrates G are loaded through the opening 83. The substrates G are supported on the support pins 103 and the movable supports 104 of the first to the third position alignment support unit 96 to 98, respectively. Next, the substrates G are position-aligned by the position alignment mechanism 86 by the following sequence.

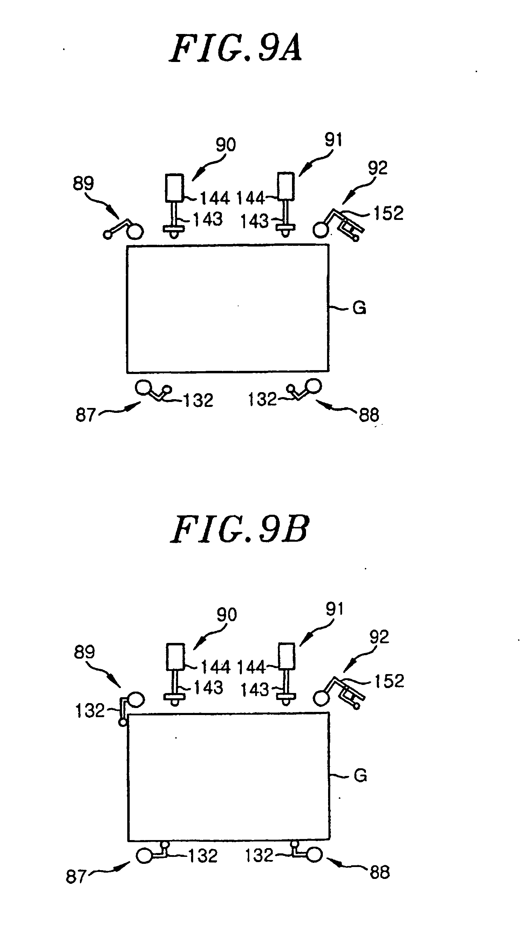

The sequence will be described with reference to schematic views of Figs. 9A to 9D.

When the substrates G are loaded, the position alignment units 87 to 89 and the pressing units 90 to 92 are in waiting or standby positions, as illustrated in Fig. 9A.

In a state where the substrates G are supported by the first to the third position alignment support unit 96 to 98, reference positions of the substrates G are set first by rotating the position alignment members 132 of the position alignment units 87 to 89 to reference positions, as can be seen from Fig. 9B. At this time, reference positions in the longer side direction of the substrates G are set first by adjusting the position alignment unit 89, and then reference positions and angles in the shorter side direction of the substrates G are set by adjusting the position alignment units 87 and 88.

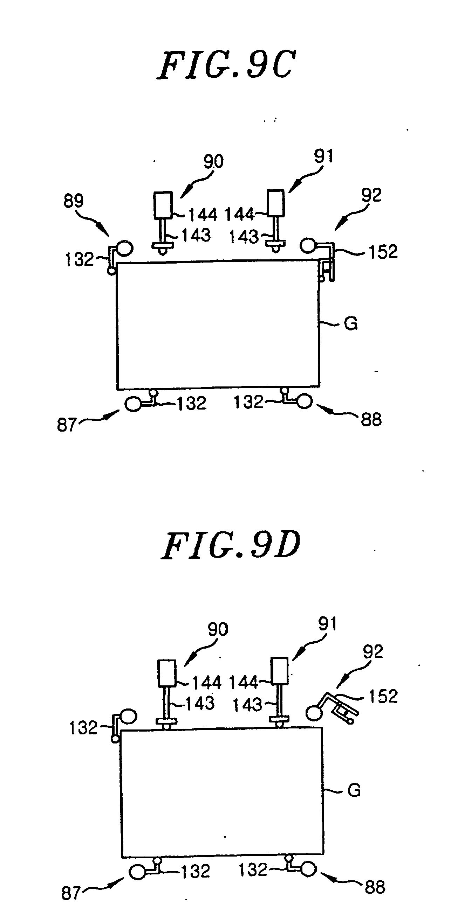

Next, as depicted in Fig. 9C, the pressing members 152 of the pressing unit 92 are rotated to press the shorter sides of the substrates G that are opposite to the shorter sides in contact with the position alignment unit 89. Accordingly, the positions in the longer side direction of the substrates G are aligned.

Then, as shown in Fig. 9D, the pistons 143 of the pressing units 90 and 91 move forward so as to press the longer sides of the substrates G that are opposite to the longer sides in contact with the position alignment units 87 and 88. Hence, the positions and angles in the shorter side direction of the substrates G are aligned. At this time, the pressing members 152 of the pressing unit 92 are retreated (i.e., moved to its standby position) so that the position alignment of the substrates G can be easily carried out.

In such manner, the substrates G can be aligned to preset positions. Such position alignment is performed to allow the substrates G to be transferred to predetermined positions in the processing chambers 30a and 30b by the substrate transfer device 50. This is because the positions of the substrates G are important in view of the uniformity of processing such as etching, film formation or the like which is performed in the processing chambers 30a and 30b.

Conventionally, a rectangular substrate has been position-aligned in a load-lock chamber by positioners for linearly moving forward and backward along a diagonal direction to press diagonally opposite corners of the substrate. Thus, a large space is required to make the positioners move, and thus, the load-lock chamber is scaled up.

On the other hand, in the position alignment mechanism 86 of the present embodiment, the position alignment members 132 of the position alignment units 87 to 89 are made to rotate to set reference positions of the substrates G. Further, in the pressing units of the present embodiment that are used to align positions of the substrates G by pressing the substrates G, the pressing unit 92 presses the substrates G by rotating the pressing members 152, and the pressing units 90 and 91 press the substrates G by allowing the pistons 143 to move forward by driving the cylinder mechanism 144 provided outside the vessel 81. Accordingly, a large space required in a conventional system is not needed, and the load-lock chamber 40 can be scaled down. Besides, in consideration of the importance of the position alignment of the substrates G, a similar position alignment mechanism can be provided to the processing chamber 30a or 30b so as to align the positions of the substrates G in the processing chamber 30a or 30b.

Moreover, each of the position alignment support units 96 to 98 is formed by alternately arranging the four support pins 103 and the five movable supports 104, so that the position alignment of the substrates G can be reliably carried out. In other words, in order to precisely align the positions of the rectangular substrates G, it may be preferable to support the substrates G at nine points. However, if the substrates G are supported by using only the supporting pins 103 at nine points, it is difficult to move the substrates G due to friction and this makes it difficult to perform position alignment of the substrates G. Further, if the substrates G are supported by using only the movable supports 104 at nine points, the substrates G can move easily, and thus, the positions of the substrates G may be easily aligned. However, it may be sometimes difficult to stop the movement of the substrates G. On the other hand, by alternately arranging the support pins 103 and the movable supports 104, the substrates G can move properly and thus can be properly position-aligned. However, when it is important to easily move the substrates G, only the movable supports 104 may be provided at nine points.

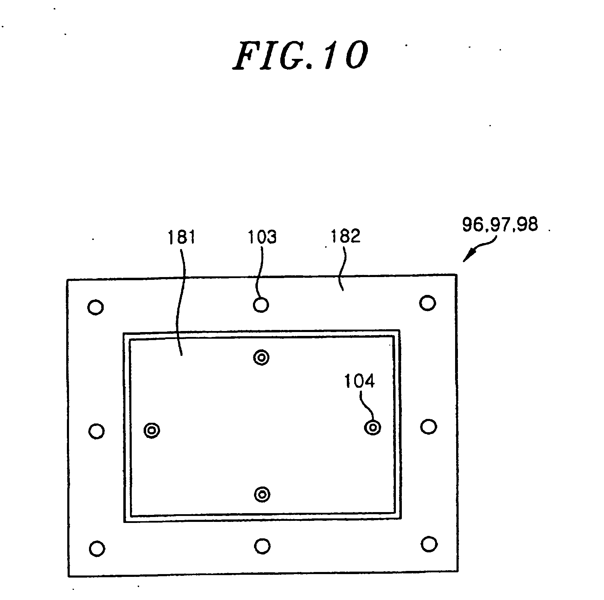

Furthermore, as for each of the position alignment support units 96 to 98, there may be used one having an inner mounting table and an outer mounting table capable of moving independently in a vertical direction to be used separately for purposes. For example, as shown in Fig. 10, it is possible to provide plural (four in the figure) movable supports 104 in the inner mounting table 181 and a plurality of (eight in the figure) support pins 103 in the outer mounting table 182. Specifically, when the substrates G need to be position-aligned, the inner mounting table 181 can be raised so that the substrates G are supported by the movable supports 104. After the position alignment is completed, the outer mounting table 182 may be raised so that the substrates G are reliably supported by the support pins 103. Alternatively, the inner mounting table 181 may be used when the substrates G is required to be moved largely for position alignment, whereas the outer mounting table 182 may be used when a required moving amount of the substrates G is small.

Besides, without being limited to the example shown in Fig. 10, the inner mounting table 181 and the outer mounting table 182 can be designed to have varying numbers of the support pins 103 and the movable supports 104 (i.e., different ratio of the number of the support pins 103 to that of the movable supports 104) depending on required amount of movement of the substrates G. The dividing method (e.g., the shapes of the divided mounting tables) and the number of the mounting tables are not limited to the example shown in Fig. 10.

The reference positions of the substrates G in the load-lock chamber 40 are determined as follows. The substrates G disposed at predetermined mounting positions in the processing chambers 30a and 30b are returned back to the load-lock chamber 40 by the substrate transfer arms 51a to 51c of the substrate transfer device 50. Next, the position alignment members 132 of the position alignment units 87 to 89 come into contact with the substrates G. The reference positions of the substrates G in the load-lock chamber 40 are determined when the positions of the position alignment members 132 of the position alignment units 87 to 89 are determined, and such positions of the position alignment members 132 are obtained from rotation positions detected by an encoder provided in the rotation driving mechanism 133. The positions thus obtained are stored in the storage unit 73 as data indicating the reference positions of the position alignment units 87 to 89.

Moreover, the reference positions of the position alignment units 87 to 89 may be different between transfer of the substrates G to the processing chamber 30a and to the processing chamber 30b. This is because, e.g., a slight error or the like may occur when the processing chambers 30a and 30b are attached to the common transfer chamber 10. In that case, it is preferable to store in the storage unit 73 both of the reference positions with respect to the processing chamber 30a and the processing chamber 30b so that reference positions can be selectively retrieved to carry out corresponding position alignment. The determination of the reference positions may be performed either in an automatic mode or manually by an operator.

Upon completion of or concurrently with the position alignment of the substrates G, the opening/closing valve 173 is closed and the opening/closing valve 163 is opened. In that state, the vacuum pump 165 is driven to reduce a pressure in the vessel 81 to a predetermined level. After the position alignment of the substrates G is completed, the loading rack 85 is raised, and the substrates G are received by the support pins 118 of the first to the third loading support 115 to 117. Then, the gate valve 63 is opened, and the substrate transfer arms 51a to 51c of the substrate transfer device 50 move into predetermined positions in the vessel 81 of the load-lock chamber 40. Thereafter, the substrates G are transferred to the transfer arms 51a to 51c by lowering the loading rack 85. Next, the substrate transfer arms 51a to 51c having the substrates G thereon return to the common transfer chamber 10, and the gate valve 63 is closed.

When the processed substrates G are exchanged with the unprocessed substrates G in the load-lock chamber 40, the unprocessed substrates G are position-aligned in the load-lock chamber 40 in the same manner. Then, the inside of the vessel 81 is set in a depressurized atmosphere, and the unprocessed substrates G are received by the support pins 118 of the first to the third loading support 115 to 117. Next, the gate valve 63 is opened, and the substrate transfer arms 51a to 51c which hold the processed substrates G move into the vessel of the load-lock chamber 40. Thereafter, the unloading rack 120 is raised so that the processed substrates G are received by the substrate support pins 128 of the first to the third unloading support 125 to 127. Next, the substrate transfer arms 51a to 51c are retreated, and the loading rack 85 is raised. Then, the substrate transfer arms 51a to 51c are positioned below the unprocessed substrates G supported by the first to the third loading supports 115 to 117, and the unprocessed substrates G are transferred onto the substrate transfer arms 51a to 51c by lowering the loading rack 85. Thereafter, the substrate transfer arms 51a to 51c having the unprocessed substrates G thereon return to the common transfer chamber 10, and the gate valve 63 is closed.

In a state where the processed substrates G are supported by the first to the third unloading support 125 to 127 of the unloading rack 120 in the load-lock chamber 40, the opening/closing valve 163 is closed and the opening/closing valve 173 is opened. Accordingly, a purge gas such as N₂ gas or the like is introduced from the purge gas supply source 175 into the vessel 81 while a flow rate is controlled by the flow rate control valve 174. Then, the inside of the vessel 81 is set in an atmospheric atmosphere, and the gate valve 64 is opened to thereby unload the processed substrates G supported by the first to the third unloading support 125 to 127 of the unloading rack 120.

In accordance with the present embodiment, in the position alignment mechanism 86 for performing position alignment of the substrates G in the load-lock chamber 40, reference positions for position alignment are set by rotating the position alignment members 132 of the position alignment units 87 to 89, and the pressing unit 92 presses the substrates G by rotating the pressing members 152. Moreover, the pressing units 90 and 91 press the substrates G by allowing the pistons 143 to move forward by driving the cylinder mechanism 144 provided outside the vessel 81. Hence, a large space required in a conventional system is not needed and the load-lock chamber 40 can be scaled down.

By alternately providing the support pins 103 and the movable supports 104 at each of the position alignment support units 96 to 98 for supporting the substrates G, the substrates G can move properly during position alignment and this ensures proper position alignment of the substrates G.

Moreover, the position alignment support units 96 to 98 can be divided into parts conferring different mobility to the substrates G and can be separately used depending on required mobility of the substrates G.

Besides, a plurality of, e.g., three, substrates G can be position-aligned, transferred and processed simultaneously, so that the processing efficiency can be increased.

Further, the present invention can be variously modified without being limited to the above-described embodiment. For example, although the substrates G are position-aligned in the load-lock chamber in the above-described embodiment, it is not limited thereto and the substrates G may be position-aligned in the processing chamber as described above. Moreover, in the above-described embodiment, three substrates are transferred and processed simultaneously by the substrate processing system. However, it is not limited thereto, and a single substrate or a plurality of (other than three) substrates may be transferred and processed by the substrate processing system. The type of the substrate processing system is not limited to one shown in Fig. 1.

In addition, although three position alignment units and three pressing units are provided in the above-described embodiment, the pressing units are not necessarily required and the number of the position alignment units is not limited to three. In addition, although the support pins and the movable supports are alternately provided at each of the position alignment support units, they may be differently arranged as long as desired mobility of the substrates can be obtained.

While the invention has been shown and described with respect to the embodiments, it will be understood by those skilled in the art that various changes and modification may be made without departing from the scope of the invention as defined in the following claims.

## Claims

1. A substrate position alignment mechanism (86) for performing position alignment of a substrate supported by each of one or more substrate support units (96, 97, 98) in a chamber (81) where the substrate is accommodated, the substrate position alignment mechanism (86) comprising one or more position alignment members (87, 88, 89), each of which is rotatable to make a contact with a side of the substrate in the chamber (81), **characterized in that**:
each of the substrate support units (96, 97, 98) is arranged to support the substrate by using a plurality of support pins (103) and plural movable supports (104) together,
wherein each of the support pins (103) is fixedly disposed and has a hemispherical leading end portion on which the substrate supportable and
wherein each of the movable supports (104) has a ball (106) on which the substrate is supportable and a receiving portion (105) into which the ball (106) is rotatably inserted.

2. The substrate position alignment mechanism (86) of claim 1, wherein the substrate has a rectangular shape and the number of the position alignment members (87, 88, 89) is at least three, and wherein the substrate is position-alignable by bringing one of the position alignment members (89) to contact with one side of the substrate and two of the position alignment members (87, 88) to contact with a side adjacent to said one side.

3. The substrate position alignment mechanism (86) of claim 2, further comprising at least three pressing members (90, 91, 92) for pressing the substrate at locations opposite to the locations brought into contact with the position alignment members (87, 88, 89), thereby position-aligning the substrate.

4. The substrate position alignment mechanism (86) of claim 3, wherein two of said at least three pressing members (141) are arranged to move forward to press a side of the substrate opposite to the side brought into contact with said two of the position alignment members (87, 88).

5. The substrate position alignment mechanism (86) of claim 4, wherein each of said two of said at least three pressing members (141) is arranged to move forward by driving a cylinder mechanism (144) provided outside the chamber (81).

6. The substrate position alignment mechanism (86) of any one of claims 3, 4 and 5, wherein one of said at least three pressing members (141) is arranged to rotate to press a side of the substrate opposite to said one side brought into contact with said one of the position alignment members (89).

7. The substrate position alignment mechanism (86) of any one of claims 1 to 6, wherein the number of the substrate support units (96, 97, 98) is greater than one and the substrate support units (96, 97, 98) are vertically overlapped by being arranged above one another at different heights, and the substrate is position-alignable while being supported by each of the substrate support units (96, 97, 98).

8. The substrate position alignment mechanism (86) of any one of claims 1 to 7, wherein the number of the substrate support units (96, 97, 98) is greater than one and the substrate support units (96, 97, 98) are vertically overlapped by being arranged above one another at different heights,
wherein each of the substrate support units (96, 97, 98) is provided with at least three position alignment members (87, 88, 89), and
wherein each of the position alignment members (87, 88, 89) is included into sets of vertically aligned position alignment members (87, 88, 89) that vertically correspond to one another, and the vertically aligned position alignment members (87, 88, 89) of each set are attached to a common rotatable shaft (131) and are rotatable in unison to be brought into contact with the substrates supported by the substrate support units (96, 97, 98) by rotating the shaft (131).

9. The substrate position alignment mechanism (86) of claim 1, wherein the support pins (103) and the movable supports (104) are arranged alternately.

10. The substrate position alignment mechanism (86) of claim 1, wherein each of the substrate support units (96, 97, 98) is divided into a plurality of parts, each part having different ratio of the number of the support pins (103) to that of the movable supports (104).

11. A vacuum prechamber (40) where one or more substrates are accommodatable and maintainable in a depressurized atmosphere before the substrates are transferred to a processing chamber (30a, 30b) for processing the substrates in the depressurized atmosphere, the vacuum prechamber (40) comprising:
a vessel (81) for accommodating the substrates;
one or more substrate support units (96, 97, 98) for supporting the substrates in the vessel (81); and
the substrate position alignment mechanism (86) of any one of claims 1 to 10, for performing position alignment of the substrates supported by the substrate support units (96, 97, 98).

12. A substrate processing system (1) comprising:
a plurality of processing chambers (30a, 30b) for performing predetermined processing on substrates in a depressurized atmosphere;
the vacuum prechamber (40) of claim 11; and
a substrate transfer device (50) for transferring the substrates between the vacuum prechamber (40) and the processing chambers (30a, 30b).

13. The substrate processing system (1) of claim 12, wherein the substrate position alignment mechanism (86) includes a plurality of reference positions of the substrates, which respectively correspond to the processing chambers (30a, 30b) to allow the substrate transfer device (50) to transfer the substrates to predetermined positions in the processing chambers (30a, 30b).

14. The substrate processing system (1) of claim 13, wherein the reference positions are determined by bringing the position alignment members (87, 88, 89) into contact with the substrates.

## Patentansprüche

1. Substratpositionsausrichtungsmechanismus (86) zum Durchführen einer Positionsausrichtung eines Substrats, das durch jede einer oder mehrerer Substratträgereinheiten (96, 97, 98) getragen ist, in einer Kammer (81), wo das Substrat untergebracht ist, wobei der Substratpositionsausrichtungsmechanismus (86) ein oder mehrere Positionsausrichtungselemente (87, 88, 89) aufweist, von welchen jedes derart rotierbar ist, dass ein Kontakt mit einer Seite des Substrats in der Kammer (81) hergestellt wird, **dadurch gekennzeichnet, dass**:
jede der Substratträgereinheiten (96, 97, 98) so angeordnet ist, dass das Substrat unter Verwendung mehrerer Trägerstifte (103) und mehrerer bewegbarer Träger (104) zusammen getragen wird,
wobei jeder der Trägerstifte (103) fest angeordnet ist und einen halbkugelförmigen Führungsendabschnitt aufweist, auf dem das Substrat tragbar ist, und
wobei jeder der bewegbaren Träger (104) eine Kugel (106), auf der das Substrat tragbar ist, und einen Aufnahmeabschnitt (105) aufweist, in den die Kugel (106) rotierbar eingesetzt wird.

2. Substratpositionsausrichtungsmechanismus (86) nach Anspruch 1, bei dem das Substrat eine rechtwinklige Form aufweist und die Anzahl an Positionsausrichtungselementen (87, 88, 89) zumindest drei beträgt und bei dem das Substrat bezüglich der Position ausrichtbar ist, und zwar durch Bringen eines der Positionsausrichtungselemente (89) in Kontakt mit einer Seite des Substrats und zwei der Positionsausrichtungselemente (87, 88) in Kontakt mit einer Seite angrenzend an die eine Seite.

3. Substratpositionsausrichtungsmechanismus (86) nach Anspruch 2, ferner mit zumindest drei Drückelementen (90, 91, 92) zum Drücken des Substrats an Stellen gegenüber den Stellen, die in Kontakt mit den Positionsausrichtungselementen (87, 88, 89) gebracht worden sind, wodurch das Substrat bezüglich der Position ausgerichtet wird.

4. Substratpositionsausrichtungsmechanismus (86) nach Anspruch 3, bei dem zwei der zumindest drei Drückelemente (141) so angeordnet sind, dass sie sich nach vorne bewegen, sodass eine Seite des Substrats gegenüber der Seite gedrückt wird, die in Kontakt mit den zwei der Positionsausrichtungselementen (87, 88) gebracht wird.

5. Substratpositionsausrichtungsmechanismus (86) nach Anspruch 4, bei dem jedes der zwei der zumindest drei Drückelemente (141) so angeordnet ist, dass es sich nach vorne durch Antreiben eines Zylindermechanismus (144) bewegt, der außerhalb der Kammer (81) vorgesehen ist.

6. Substratpositionsausrichtungsmechanismus (86) nach einem der Ansprüche 3, 4 und 5, bei dem eines der zumindest drei Drückelemente (141) so angeordnet ist, dass es rotiert, sodass eine Seite des Substrats gegenüber der einen Seite gedrückt wird, die in Kontakt mit dem einen der Positionsausrichtungselemente (89) gebracht worden ist.

7. Substratpositionsausrichtungsmechanismus (86) nach einem der Ansprüche 1 bis 6, bei dem die Anzahl der Substratträgereinheiten (96, 97, 98) größer als eins ist und die Substratträgereinheiten (96, 97, 98) durch Anordnen übereinander bei unterschiedlichen Höhen vertikal überlappt sind und das Substrat bezüglich der Position ausrichtbar ist, während es durch jede der Substratträgereinheiten (96, 97, 98) getragen wird.

8. Substratpositionsausrichtungsmechanismus (86) nach einem der Ansprüche 1 bis 7, bei dem die Anzahl der Substratträgereinheiten (96, 97, 98) größer als eins ist und die Substratträgereinheiten (96, 97, 98) dadurch vertikal überlappen, dass sie übereinander bei unterschiedlichen Höhen angeordnet sind,
wobei jede der Substratträgereinheiten (96, 97, 98) mit zumindest drei Positionsausrichtungselementen (87, 88, 89) versehen ist und
wobei jedes der Positionsausrichtungselemente (87, 88, 89) in Sätzen vertikal ausgerichteter Positionsausrichtungselemente (87, 88, 89) enthalten ist, die vertikal einander entsprechen, und die vertikal ausgerichteten Positionsausrichtungselemente (87, 88, 89) jedes Satzes an einer gemeinsamen rotierbaren Welle (131) angebracht sind und im Gleichklang rotierbar sind, sodass sie in Kontakt mit den Substraten durch Rotation der Welle (131) rotierbar sind, um in Kontakt mit den Subtraten gebracht zu werden, die durch die Substratträgereinheiten (96, 97, 98) getragen werden.

9. Substratpositionsausrichtungsmechanismus (86) nach Anspruch 1, bei dem die Trägerstifte (103) und die bewegbaren Träger (104) abwechselnd angeordnet sind.

10. Substratpositionsausrichtungsmechanismus (86) nach Anspruch 1, bei dem jede der Substratträgereinheiten (96, 97, 98) in mehrere Teile geteilt ist, wobei jeder Teil unterschiedliche Verhältnisse der Anzahl der Trägerstifte (103) zu der der bewegbaren Träger (104) aufweist.

11. Vakuumvorkammer (40), wo ein oder mehrere Substrate untergebracht werden können und in einer Atmosphäre, deren Druck herabgesetzt worden ist, haltbar sind, bevor die Substrate zu einer Bearbeitungskammer (30a, 30b) zum Bearbeiten der Substrate in die Atmosphäre, deren Druck herabgesetzt worden ist, übertragen werden, wobei die Vakuumvorkammer (40) aufweist:
einen Behälter (81) zum Aufbewahren der Substrate;
eine oder mehrere Substratträgereinheiten (96, 97, 98) zum Tragen der Substrate in dem Behälter (81); und
den Substratpositionsausrichtungsmechanismus (86) nach einem der Ansprüche 1 bis 10 zum Durchführen einer Positionsausrichtung der Substrate, die durch die Substratträgereinheiten (96, 97, 98) getragen werden.

12. Substratbearbeitungssystem (1) mit:
mehreren Bearbeitungskammern (30a, 30b) zum Durchführen einer vorbestimmten Bearbeitung an Substraten in einer Atmosphäre, deren Druck herabgesetzt worden ist;
der Vakuumvorkammer (40) nach Anspruch 11; und
einer Substratübertragungsvorrichtung (50) zum Übertragen der Substrate zwischen der Vakuumvorkammer (40) und den Bearbeitungskammern (30a, 30b).

13. Substratbearbeitungssystem (1) nach Anspruch 12, bei dem der Substratpositionsausrichtungsmechanismus (86) mehrere Referenzpositionen der Substrate aufweist, die jeweils den Bearbeitungskammern (30a, 30b) entsprechen, um zu ermöglichen, dass die Substratübertragungsvorrichtung (50) die Substrate zu vorbestimmten Positionen in den Bearbeitungskammern (30a, 30b) überträgt.

14. Substratbearbeitungssystem (1) nach Anspruch 13, bei dem die Referenzpositionen dadurch bestimmt werden, dass die Positionsausrichtungselemente (87, 88, 89) in Kontakt mit den Substraten gebracht werden.

## Revendications

1. Mécanisme d'alignement de position de substrat (86) pour effectuer un alignement de position d'un substrat supporté par chacune d'une ou plusieurs unités de support de substrat (96, 97, 98) dans une chambre (81) où le substrat est logé, le mécanisme d'alignement de position de substrat (86) comprenant un ou plusieurs éléments d'alignement de position (87, 88, 89), chacun d'eux étant rotatif pour établir un contact avec un côté du substrat dans la chambre (81), **caractérisé en ce que** :
chacune des unités de support de substrat (96, 97, 98) est agencée pour supporter le substrat en utilisant une pluralité d'ergots de support (103) et plusieurs supports mobiles (104) ensemble,
dans lequel chacun des ergots de support (103) est disposé de manière fixe et a une partie d'extrémité de tête hémisphérique sur laquelle le substrat peut être supporté, et
dans lequel chacun des supports mobiles (104) a une bille (106) sur laquelle le substrat peut être supporté et une partie de réception (105) dans laquelle la bille (106) est insérée en rotation.

2. Mécanisme d'alignement de position de substrat (86) selon la revendication 1, dans lequel le substrat a une forme rectangulaire et le nombre des éléments d'alignement de position (87, 88, 89) est au moins trois, et dans lequel le substrat peut subir un alignement de position en amenant un des éléments d'alignement de position (89) à entrer en contact avec un côté particulier du substrat et deux des éléments d'alignement de position (87, 88) à entrer en contact avec un côté adjacent audit côté particulier.

3. Mécanisme d'alignement de position de substrat (86) selon la revendication 2, comprenant en outre au moins trois éléments de pression (90, 91, 92) pour presser le substrat en des emplacements opposés aux emplacements amenés en contact avec les éléments d'alignement de position (87, 88, 89), alignant de ce fait la position du substrat.

4. Mécanisme d'alignement de position de substrat (86) selon la revendication 3, dans lequel deux desdits au moins trois éléments de pression (141) sont agencés pour avancer pour presser un côté du substrat opposé au côté amené en contact avec lesdits deux éléments d'alignement de position (87, 88).

5. Mécanisme d'alignement de position de substrat (86) selon la revendication 4, dans lequel chacun desdits deux desdits au moins trois éléments de pression (141) est agencé pour avancer en entraînant un mécanisme de vérin (144) disposé à l'extérieur de la chambre (81).

6. Mécanisme d'alignement de position de substrat (86) selon l'une quelconque des revendications 3, 4 et 5, dans lequel l'un desdits au moins trois éléments de pression (141) est agencé pour tourner pour presser un côté du substrat opposé audit côté particulier amené en contact avec ledit élément particulier des éléments d'alignement de position (89).

7. Mécanisme d'alignement de position de substrat (86) selon l'une quelconque des revendications 1 à 6, dans lequel le nombre des unités de support de substrat (96, 97, 98) est supérieur à un et les unités de support de substrat (96, 97, 98) se chevauchent verticalement en étant agencées les unes au-dessus des autres à des hauteurs différentes, et le substrat peut subir un alignement de position tout en étant supporté par chacune des unités de support de substrat (96, 97, 98).

8. Mécanisme d'alignement de position de substrat (86) selon l'une quelconque des revendications 1 à 7, dans lequel le nombre des unités de support de substrat (96, 97, 98) est supérieur à un et les unités de support de substrat (96, 97, 98) se chevauchent verticalement en étant agencées les unes au-dessus des autres à des hauteurs différentes,
dans lequel chacune des unités de support de substrat (96, 97, 98) est munie d'au moins trois éléments d'alignement de position (87, 88, 89), et
dans lequel chacun des éléments d'alignement de position (87, 88, 89) est inclus dans des ensembles d'éléments d'alignement de position verticalement alignés (87, 88, 89) qui correspondent verticalement les uns aux autres, et les éléments d'alignement de position verticalement alignés (87, 88, 89) de chaque ensemble sont attachés à un arbre rotatif commun (131) et sont rotatifs à l'unisson pour être amenés en contact avec les substrats supportés par les unités de support de substrat (96, 97, 98) en faisant tourner l'arbre (131).

9. Mécanisme d'alignement de position de substrat (86) selon la revendication 1, dans lequel les ergots de support (103) et les supports mobiles (104) sont agencés en alternance.

10. Mécanisme d'alignement de position de substrat (86) selon la revendication 1, dans lequel chacune des unités de support de substrat (96, 97, 98) est divisée en une pluralité de parties, chaque partie ayant un rapport différent du nombre des ergots de support (103) sur celui des supports mobiles (104).

11. Préchambre à vide (40) où un ou plusieurs substrats peuvent être logés et maintenus dans une atmosphère dépressurisée avant que les substrats ne soient transférés vers une chambre de traitement (30a, 30b) pour traiter les substrats dans l'atmosphère dépressurisée, la préchambre à vide (40) comprenant :
un récipient (81) pour loger les substrats ;
une ou plusieurs unités de support de substrat (95, 97, 98) pour supporter les substrats dans le récipient (81) ; et
le mécanisme d'alignement de position de substrat (86) selon l'une quelconque des revendications 1 à 10, pour effectuer un alignement de position des substrats supportés par les unités de support de substrat (96, 97, 98).

12. Système de traitement de substrat (1) comprenant :
une pluralité de chambres de traitement (30a, 30b) pour effectuer un traitement prédéterminé sur des substrats dans une atmosphère dépressurisée ;
la préchambre à vide (40) selon la revendication 11 ; et
un dispositif de transfert de substrat (50) pour transférer les substrats entre la préchambre à vide (40) et les chambres de traitement (30a, 30b).

13. Système de traitement de substrat (1) selon la revendication 12, dans lequel le mécanisme d'alignement de position de substrat (86) inclut une pluralité de positions de référence des substrats, qui correspondent respectivement aux chambres de traitement (30a, 30b) pour permettre au dispositif de transfert de substrat (50) de transférer les substrats vers des positions prédéterminées dans les chambres de traitement (30a, 30b).

14. Système de traitement de substrat (1) selon la revendication 13, dans lequel les positions de référence sont déterminées en amenant les éléments d'alignement de position (87, 88, 89) en contact avec les substrats.
